# FASCICULE DE BREVET EUROPEEN

(11) **EP 1 049 220 B1**
(45) Date de publication et mention de la délivrance du brevet: **03.06.2009**
(21) Numéro de dépôt: 00401137.5
(22) Date de dépôt: 25.04.2000
(51) Int. Cl.: H01S 5/14

(54) **Laser à gamme de température de fonctionnement étendue**
Laser mit erweitertem Arbeitstemperaturbereich
Laser having an extended operating temperature range

(30) Priorité: 30.04.1999 FR 9905528
(43) Date de publication de la demande: 02.11.2000
(73) Titulaire: Avanex Corporation, Fremont, CA 94538 (US)
(72) Inventeur: Bettiati, Mauro, 75005 Paris (FR); Gelly, Gérard, 91630 Cheptainville (FR)
(74) Mandataire: Feray, Valérie

(56) Documents cités:
- EP-A- 0 772 267
- US-A- 5 563 732
- US-A- 5 715 263
- PATENT ABSTRACTS OF JAPAN vol. 1997, no. 10, 31 octobre 1997 (1997-10-31) & JP 09 148660 A (MITSUBISHI ELECTRIC CORP), 6 juin 1997 (1997-06-06)

## Description

### Domaine technique

L'invention se situe dans le domaine des lasers à puits quantiques comportant un moyen de réflexion extérieur à la cavité du laser.

### Arrière plan technologique

On connaît par exemple par le brevet US-A-5,715,263 délivré à SDL un laser représenté en figure 2 de ce brevet et comportant un laser à puits quantiques 26 ayant un miroir de sortie 27 et alimentant une fibre optique 32. Un tel laser est utilisé en télécommunication pour pomper un amplificateur alimentant une ligne de transmission. Selon l'invention décrite dans le brevet SDL la fibre 32 comporte un réseau de Bragg sur fibre 34, ayant pour fonction de réfléchir une partie de la lumière émise par le laser 26 de nouveau vers le laser 26. Il est expliqué dans ce brevet (col 2, lignes 37-45) que si le centre de la bande de réflexion du réseau de Bragg de la fibre est dans la bande de gain du laser, cela affecte le spectre optique de la diode laser émettrice. L'effet exact est fonction de paramètres tels que la valeur du coefficient de réflexion du réseau de Bragg de la fibre, sa largeur de bande, la longueur d'onde centrale du réseau par rapport au laser, la valeur de la distance optique entre le laser et le réseau, et de la valeur du courant injecté dans le laser. Dans le brevet SDL la longueur d'onde centrale du réseau de Bragg est contenue à l'intérieur d'une bande de 10 nm autour de la longueur d'onde du laser et le coefficient de réflexion du réseau 34 a une valeur similaire à celle de la face de sortie 27 du laser 26. Dans le mode préféré de réalisation la largeur de la bande réfléchie par le réseau 34 et son coefficient de réflexion sont tels que le retour dans la cavité laser dû à la face de sortie, est plus grand que le retour dû au réseau 34. De la sorte le réseau 34 agit comme une perturbation du spectre d'émission de la diode laser 26, ce qui a pour effet d'élargir la bande d'émission et ainsi de rendre la diode moins sensible aux perturbations dues aux changements de température ou de courants injectés.

Pour obtenir l'effet recherché, dans le mode de réalisation préféré, le réseau 34 a un pic de réflexion qui se situe à 1 ou 2 nm de la longueur d'onde de la diode, un coefficient de réflexion de 3%, ce qui compte tenu du couplage entre le réseau et la diode conduit à un coefficient de retour vers la diode de 1,08%.

On connaît également par le brevet US-A-5.563.732 délivré à AT&T Corp. un laser 13 de pompage d'un laser amplificateur 12 utilisé également pour réaliser des transmissions optiques. Ce laser 12 est stabilisé pour éviter les fluctuations de longueur d'onde émises, provoquées par les réflexions parasites en provenance du laser amplificateur 12, au moyen d'un réseau sur fibre 14. Les inventeurs établissent que le laser de pompage 13 est stabilisé si le coefficient de réflexion du réseau 14 est compris entre 5 et 43 dB.

JP 9148660 décrit un moyen de maintenir un gain élevé pour un PDF et d'assurer une source de lumière pour pomper, de manière asservie, une puce laser semi-conductrice selon une étendue de longueur d'onde spécifiée qui présente un pic de gain dans l'étendue en longueur d'onde spécifiée en produisant une résonance laser. Pour cela une lentille comprenant un film basse réflexion et un film haute réflexion concentre la lumière laser issue de la puce laser semi-conductrice avant diffraction de la lumière et guide la lumière vers une fibre optique. La puce laser semi-conductrice émet spontanément une lumière présentant un pic de gain dans l'étendue de longueur d'onde comprise entre 0, 975 et 0, 994 µm. Une partie de la lumière spontanément émise est réinjectée à la puce laser semi-conductrice. Ainsi une résonance laser est produite entre le film haute réflexion et un réseau de diffraction, et la lumière résonante est appliquée au pompage d'un PDF.

EP 0772267 décrit une diode laser de type distribuée asservie dans la bande 1,3 µm décalée de lambda/4, comprenant une couche active comportant de multiples puits quantiques, une longueur de résonateur de 300 à 600 µm, désaccordée de -15 à +15 nm, à température ambiante, et un nombre de puits quantiques de 8 à 15 ou un facteur de confinement de lumière dans la couche de puit quantique de 3 à 10%.

Les expériences menées par la demanderesse ont montré que l'utilisation de lasers stabilisés au moyen d'un réseau de fibre pouvait effectivement avoir une bonne influence sur la stabilité de fonctionnement du laser et en particulier sur la stabilité de la longueur d'onde émise, mais à l'intérieur de certaines limites. En particulier l'usage de lasers stabilisés de la manière décrite dans chacun des deux brevets cités ci-dessus ne permet pas d'obtenir un laser qui puisse fonctionner dans une gamme de température allant de - 20° C à + 70°C comme actuellement requis par la plupart des utilisateurs. Il existe donc un besoin pour un tel laser.

### Brève description de l'invention

L'invention vise un laser à puits quantique comme ceux qui sont décrits dans les deux documents précités, mais qui soit capable d'opérer sans précautions particulières dans une gamme de température comprise entre deux températures limites distantes l'une de l'autre de 100° environ, en particulier dans la gamme de température comprise entre - 20° C et + 70°C. Il convient tout d'abord de bien comprendre que fonctionner entre -20° C et + 70°C n'est pas la même chose qu'élargir la bande de fonctionnement afin d'avoir une bande de longueur d'onde de sortie indépendante de fluctuations raisonnables de la température de fonctionnement, par exemple dans une gamme de température fluctuant de 5 à 6° autour d'une température nominale de fonctionnement.

L'invention utilise comme dans l'art antérieur un laser à puits quantique ayant une cavité laser formée par un milieu laser entre une face de réflexion et une face de sortie ayant un coefficient de réflexion,
- des moyens de couplage de la sortie laser à une fibre optique,
- la fibre optique ayant un réseau sur fibre renvoyant vers la cavité laser par l'intermédiaire des moyens de couplage une fraction de la lumière reçue du laser par la fibre.

L'invention diffère toutefois de l'art antérieur par une caractéristique importante. Les inventeurs ont observé que, à une température donnée, la courbe de gain de la cavité en fonction de la longueur d'onde, présente en allant dans le sens des longueurs d'onde croissantes, une pente positive, un maximum pour une longueur d'onde λₘₐₓ puis une pente négative. La pente positive a un coefficient de pente qui est beaucoup plus faible que le coefficient de pente qui suit le maximum. En observant la façon dont se déforme la courbe de gain en fonction de la température ils ont constaté que le maximum se déplaçait, par exemple pour un laser fonctionnant à 980 nm à 25°C, entre 966 à - 20°C et environ 995 nm à 70°C. Le déplacement est sensiblement linéaire avec un coefficient d'environ 0,3 nm par degré. Pour que le système fonctionne sur une large gamme de température, il faut que sur toute la gamme de température la condition selon laquelle le gain de la cavité est égal aux pertes de la cavité, soit vérifiée pour la longueur d'onde du réseau de Bragg de la fibre, malgré les déformations apportées à la courbe de gain de la cavité en fonction de la longueur d'onde, par les variations de température. Pour que cette dernière condition soit remplie, les inventeurs ont trouvé qu'il suffisait qu'à la température médiane de la gamme de fonctionnement la longueur d'onde de réflexion du réseau de la fibre ait une valeur qui soit inférieure d'au moins 10 nm à la valeur de la longueur d'onde λₘₐₓ donnant un gain maximum à la cavité. En pratique la différence à prévoir est de 15 plus ou moins 5 nm. Le fait de se placer à une valeur de longueur d'onde se situant à une valeur d'environ 15 nm avant ce maximum, permet de satisfaire pour une large gamme de températures la condition de seuil selon laquelle le gain est égal aux pertes, à la longueur d'onde du réseau.

En résumé l'invention est relative à un dispositif optique selon la revendication 1 comprenant :
- un laser à puits quantiques ayant une cavité laser formée par un milieu laser entre une face de réflexion et une face de sortie renvoyant vers la cavité une partie de l'énergie lumineuse, la cavité ayant une courbe de gain en fonction de la longueur d'onde présentant pour des longueurs d'onde croissantes une pente positive, un maximum pour une longueur d'onde λₘₐₓ puis une pente négative,
- des moyens de couplage de la sortie laser à une fibre optique, la fibre optique ayant un réseau sur fibre définissant un coefficient d'un pic de réflexion pour une longueur d'onde λ et renvoyant vers la cavité laser au travers les moyens de couplage une fraction de la lumière reçue du laser par la fibre,
- dispositif caractérisé en ce que la valeur de la longueur d'onde λ définissant le pic de réflexion du réseau de Bragg de la fibre est inférieure d'au moins 13 nanomètres à la valeur de la longueur d'onde λₘₐₓ à la température ambiante de 25°C.

De préférence l'énergie reçue par la cavité laser en retour du réseau sur fibre est supérieure à l'énergie reçue en retour par la face de sortie du laser.

Cette caractérisation fonctionnelle peut être précisée par une caractérisation structurelle définissant un rapport liant les coefficients de la face de sortie du laser et le coefficient de réflexion du réseau. Il faut que le produit du coefficient de réflexion du réseau de fibre par le carré du coefficient de perte dû au couplage entre la fibre et le laser soit supérieur au coefficient de réflexion de la face de sortie de la cavité. De cette façon l'énergie reçue en retour du réseau de fibre ne peut plus être considérée comme une perturbation élargissant le spectre optique de sortie. La valeur de la longueur d'onde réfléchie par le réseau détermine la valeur de la longueur d'onde de sortie du laser. De façon connue la valeur de la longueur d'onde λ réfléchie par le réseau sur fibre varie beaucoup moins avec la température que ne le fait la cavité. Il en résulte qu'avec cette configuration le système optique constitué par le laser, la fibre, et les moyens de couplage est capable de fonctionner en dépendant moins de variations locales de température. Dans un mode de réalisation de l'invention, la valeur du coefficient de réflexion du réseau est plus de 10 fois supérieure au coefficient de réflexion de la face de sortie du laser.

### Brève description des dessins.

Un exemple de réalisation de l'invention sera maintenant commenté et expliqué à l'aide des dessins annexés dans lesquels :
- La figure 1 est un schéma représentant un mode de réalisation de l'invention.
- La figure 2 est un ensemble de trois paires de courbes chaque paire représentant le gain et les pertes de la cavité laser respectivement. La paire de courbes A représente le gain et les pertes de la cavité laser à 25°C, la paire de courbes B à 70°C, la paire de courbes C à -20°C.

### Description et commentaires d'un mode de réalisation

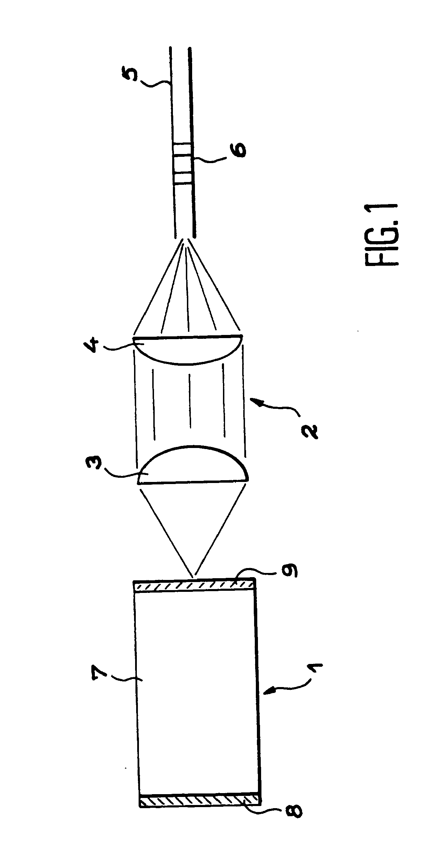

La figure 1 représente de façon schématique et connue en soit une cavité laser 1 disposée de façon que le faisceau laser émis soit dirigé par des moyens optiques de focalisation 2, dans une fibre optique 5 comportant de façon connue un réseau sur fibre 6. Le laser 1 peut de façon connue et décrite par exemple dans le brevet déjà cité US-A- 5,715,263 être constitué par une diode laser comportant une structure épitaxiée à puits quantique ou encore un milieu semi-conducteur InGaAs agencés entre un miroir réfléchissant 8 et une face de sortie 9 ayant un coefficient de réflexion très faible par rapport à celui du miroir 8. La cavité laser est formée entre les miroirs 8 et 9.

Les moyens optiques de focalisation sont de façon connue en soi constitués par une première lentille de collimation 3 suivi d'une lentille de focalisation 4, focalisant la lumière vers le centre de la fibre 5.

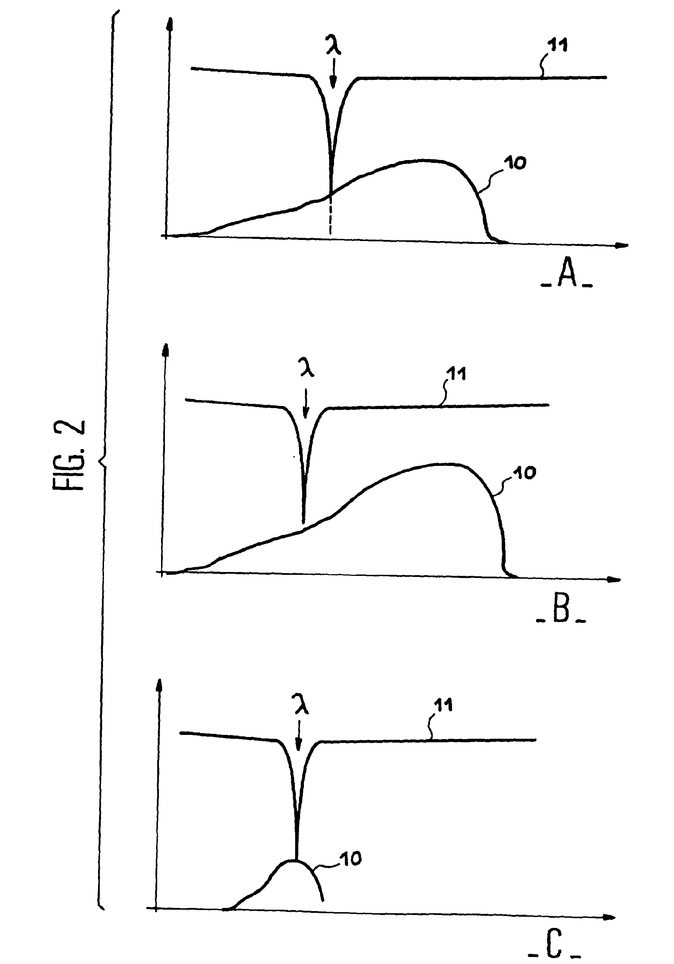

Les traits caractéristiques de l'invention seront maintenant expliqués et commentés en liaison avec les courbes de la figure 2. La partie A de la figure représente la courbe 10 du gain de la cavité laser en fonction de la longueur d'onde et la courbe 11 représente les pertes de cette même cavité en fonction de la longueur d'onde. Le laser ne peut fonctionner que dans la mesure où les pertes sont inférieures au gain. Dans le cas du dispositif représenté figure 1, la valeur des coefficients de réflexion respectifs de la face de sortie 9 de la cavité et du réseau 6 sont telles que cela ne se produit que pour la longueur d'onde λ qui est la longueur d'onde de réflexion du réseau 6. Cela est dû au fait que la lumière réfléchie par le réseau est supérieure à la quantité de lumière réfléchie par la face de sortie 9. Dans le cas représenté sur la figure 1 la valeur du coefficient de réflexion de la face de sortie 9 est typiquement de 0,1% alors que la valeur du coefficient de réflexion du réseau 6 est typiquement de l'ordre du pour cent tout en restant inférieure ou égal à 5%. Avec cette façon de choisir les valeurs relatives des coefficients de réflexion la fréquence d'émission du laser à l'intérieur de la plage autorisée par le milieu est déterminée par la longueur d'onde de réflexion du réseau. Il en résulte comme expliqué plus haut une grande stabilité de fonctionnement. On va s'intéresser aux déformations des courbes 10 et 11 lorsque la température varie. Les courbes de la partie A sont représentatives du fonctionnement à 25°C. Les même courbes 10 et 11 ont été représentées en partie B et C de la figure 2 pour des valeurs de température de + 70°C et - 20°C respectivement. On observe tout d'abord que la courbe 11 représentant les pertes ne subit pratiquement aucune déformation, tout au plus la valeur de λ se trouve-t-elle légèrement déplacée. La courbe 10 des gains présente pour les faibles valeurs de longueur d'onde une pente positive faible puis un maximum et enfin une pente négative abrupte. Ceci se vérifie pour les trois températures représentées. On voit que pour des températures croissantes le maximum se déplace de façon relativement importante vers des valeurs croissantes de longueur d'onde, que le maximum croît avec la température en sorte que la longueur de la ligne de pente positive s'allonge. Les inventeurs ont choisi comme valeur de la longueur d'onde λ de réflexion du réseau 6, à la température médiane de la gamme de température de fonctionnement souhaitée, une valeur inférieure d'environ 13 nm à la valeur de la longueur d'onde du maximum de la courbe de gain 10 à cette même température. Dans le cas présent la gamme de fonctionnement souhaitée est de -20° C à + 70°C. La température médiane de la gamme est donc 25°C. Avec ce choix comme représenté en partie B il existe toujours à la température haute de la gamme, un point de fonctionnement possible et stable pour la valeur de longueur d'onde λ de réflexion du réseau 6 à cette température. De même à -20°C, température basse de la gamme, il existe encore un point de fonctionnement, ici comme représenté en partie C de la figure 2, le maximum de la courbe 10, qui se situe à une valeur de longueur d'onde qui est voisine de la longueur d'onde λ de réflexion du réseau 6 à cette température. Ainsi le laser fonctionne bien dans la gamme de température souhaitée

Le laser selon l'invention peut naturellement être utilisé aux même fins que celles décrites dans l'art antérieur cité et consistant notamment à pomper un laser de puissance constitué par une fibre dopée à l'erbium.

## Revendications

1. Dispositif optique comprenant :
- un laser à puits quantiques ayant une cavité laser formée par un milieu laser entre une face de réflexion (8) et une face de sortie (9) renvoyant vers la cavité une partie de l'énergie lumineuse, la cavité ayant une courbe de gain en fonction de la longueur d'onde présentant pour des longueurs d'onde croissantes une pente positive, un maximum pour une longueur d'onde λₘₐₓ puis une pente négative,
- des moyens de couplage (2,3,4) de la sortie laser à une fibre optique (5), la fibre optique ayant un réseau sur fibre (6) définissant un coefficient d'un pic de réflexion pour une longueur d'onde λ et renvoyant vers la cavité laser au travers les moyens de couplage (2,3,4) une fraction de la lumière reçue du laser par la fibre,
- dispositif **caractérisé en ce que** la valeur de la longueur d'onde λ définissant le pic de réflexion du réseau de Bragg de la fibre est inférieure d'au moins 13 nm à la valeur de la longueur d'onde λₘₐₓ à la température ambiante de 25°C.

2. Dispositif optique selon la revendication 1 **caractérisé en ce que** la valeur de la longueur d'onde λ définissant le pic de réflexion du réseau de Bragg de la fibre est inférieure de 15 plus 5 nm ou moins 2 nm à la valeur de la longueur d'onde λₘₐₓ à la température ambiante de 25°C.

3. Dispositif optique selon la revendication 1 ou 2 **caractérisé en ce que** la valeur du coefficient de réflexion du réseau (6) est plus de 10 fois supérieure au coefficient de réflexion de la face (9) de sortie du laser.

4. Dispositif optique selon l'une quelconque des revendications 1 à 3, **caractérisé en ce que** la longueur d'onde λₘₐₓ est une longueur d'onde qui a une valeur supérieure d'environ 13 nm à la valeur de la longueur d'onde λ pour laquelle le réseau (6) présente un pic de réflexion lorsque la température de fonctionnement a une valeur égale à 25°C.

## Claims

1. An optical device, comprising:
- a quantum well laser having a laser cavity formed by a laser medium between a reflection face (8) and an output face (9) returning towards the cavity part of the light energy, with the cavity having a gain curve depending on the wavelength, which has a positive slope for increasing wavelengths, a maximum for a wavelength λₘₐₓ, and then a negative slope,
- means (2, 3, 4) for coupling the laser output to an optical fiber (5), the optical fiber having a fiber grating (6) defining a coefficient of a reflection peak for a wavelength λ and returning to the laser cavity through the coupling means (2, 3, 4) a fraction of the light received from the laser by the fiber,
- the device being **characterized in that** the value of the wavelength λ defining the reflection peak of the Bragg grating of the fiber is lower by at least 13 nm than the value of the wavelength λₘₐₓ at the ambient temperature of 25 °C.

2. The optical device according to claim 1, **characterized in that** the value of the wavelength λ defining the reflection peak of the Bragg grating of the fiber is lower by 15 plus 5 nm, or at least 2 nm, than the value of the wavelength λₘₐₓ at the ambient temperature of 25 °C.

3. The optical device according to claim 1 or 2, **characterized in that** the value of the reflection coefficient of the grating (6) is more than 10 times greater than the reflection coefficient of the laser output face (9).

4. The optical device according to any of claims 1 to 3, **characterized in that** the wavelength λₘₐₓ is a wavelength having a value greater by about 13 nm than the value of the wavelength λ for which the grating (6) has a reflection peak when the operating temperature has a value of 25 °C.

## Patentansprüche

1. Optische Vorrichtung, umfassend:
- einen Quantentopflaser mit einem Laserhohlraum, der gebildet wird aus einem Lasermedium zwischen einer Reflexionsseite (8) und einer Auskopplungsseite (9), die einen Teil der Lichtenergie in den Hohlraum zurückstrahlt, wobei der Hohlraum eine von der Wellenlänge abhängige Verstärkungskurve aufweist, die für zunehmende Wellenlängen eine positive Steigung, für eine Wellenlänge λₘₐₓ ein Maximum und dann eine negative Steigung aufweist,
- Mittel (2, 3, 4) zum Koppeln des Laserausgangs an eine Lichtleitfaser (5), wobei die Lichtleitfaser ein Fasergitter (6) aufweist, das einen Koeffizienten einer Reflexionsspitze für eine Wellenlänge λ definiert und in den Laserhohlraum über die Kopplungsmittel (2, 3, 4) einen Bruchteil des Lichts zurückstrahlt, das von dem Laser durch die Faser empfangen wird,
- wobei die Vorrichtung **dadurch gekennzeichnet ist, dass** der Wert der Wellenlänge λ, welche die Reflexionsspitze des Bragg-Gitters der Faser definiert, um mindestens 13 nm geringer ist als der Wert der Wellenlänge λₘₐₓ bei der Umgebungstemperatur von 25 °C.

2. Optische Vorrichtung nach Anspruch 1, **dadurch gekennzeichnet, dass** der Wert der Wellenlänge λ, welche die Reflexionsspitze des Bragg-Gitters der Faser definiert, um 15 plus 5 nm oder mindestens 2 nm geringer ist als der Wert der Wellenlänge λₘₐₓ bei der Umgebungstemperatur von 25 °C.

3. Optische Vorrichtung nach Anspruch 1 oder 2, **dadurch gekennzeichnet, dass** der Wert des Reflexionskoeffizienten des Gitters (6) mehr als 10mal größer ist als der Reflexionskoeffizient der Laserauskopplungsseite (9).

4. Optische Vorrichtung nach einem der Ansprüche 1 bis 3, **dadurch gekennzeichnet, dass** die Wellenlänge λₘₐₓ eine Wellenlänge ist, die einen Wert aufweist, der um ungefähr 13 nm größer ist als der Wert der Wellenlänge λ, für die das Gitter (6) eine Reflexionsspitze aufweist, wenn die Betriebstemperatur einen Wert von 25 °C hat.
